(19) **Europäisches Patentamt**

**European Patent Office**

**Office européen des brevets**

(11) Veröffentlichungsnummer: **0 268 890 B1**

(12) **EUROPÄISCHE PATENTSCHRIFT**

(45) Veröffentlichungstag der Patentschrift: **26.02.92**

(51) Int. Cl.⁵: **H01R 9/09**

(21) Anmeldenummer: **87116267.3**

(22) Anmeldetag: **05.11.87**

(54) **Steckkontakt.**

(30) Priorität: **08.11.86 DE 3638154**

(43) Veröffentlichungstag der Anmeldung:
**01.06.88 Patentblatt 88/22**

(45) Bekanntmachung des Hinweises auf die
Patenterteilung:
**26.02.92 Patentblatt 92/09**

(84) Benannte Vertragsstaaten:
**AT BE CH DE FR GB IT LI NL SE**

(56) Entgegenhaltungen:
EP-A- 0 140 615         FR-A- 1 417 100
FR-A- 2 183 154         GB-A- 2 103 431
US-A- 1 806 815         US-A- 3 832 603

(73) Patentinhaber: **Inotec Electronics GmbH**
**Theodor-Heuss-Strasse 9**
**W-7100 Heilbronn(DE)**

(72) Erfinder: **Schmitt, Fred R.**
**Hühnerbrünnele 13**
**W-7129 Talheim/Neckar(DE)**

(74) Vertreter: **Müller, Hans**
**Patentanwaltskanzlei Müller und Clemens**
**Lerchenstrasse 56**
**W-7100 Heilbronn(DE)**

**Beschreibung**

TECHNISCHES GEBIET

Die Erfindung betrifft Steckkontakte zum Durchkontaktieren von Lochrasterplatten, die jeder einen etwa zylindrischen, langgezogenen Körper besitzen, der durch jeweils ein Loch der Platte hindurchsteckbar ist.

STAND DER TECHNIK

Für den manuellen Aufbau von elektronischen Versuchs- und Prototypenschaltungen werden von den Entwicklern meist die vom Markt in vielfältiger Ausführung angebotenen System-Leiterplatten, vorwiegend in Europa- oder Doppeleuropaformat (E1-, E2-Platten) verwendet.

Diese Leiterplatten können je nach System des Anbieters auf einer Lochrasterplatte ein- oder zweiseitig in einem Rastersprung aufgebrachte Kupferbahnen oder in einem vorbestimmten Raster zusammengefaßte Kupferleitungszüge aufweisen. Ganz einfache Ausführungen bestehen nur aus einer Lochrasterplatte mit einseitig um die Bohrungen umlaufenden sogenannten Lötaugen.

Der Nachteil bei der Verwendung solcher Systemplatten liegt darin, daß sie nie optimal den unterschiedlichsten Anforderungen gerecht werden können, da die auf der Leiterplatte bereits installierten Leitungsverbindungen zwischen bestimmten Löchern der Platte in aller Regel nicht den individuell geforderten Leitungsverbindungen entsprechen. So müssen die auf der Leiterplatte anzuordnenden elektronischen Bauteile untereinander durch zusätzlich angelötete Drähte miteinander verbunden und darüber hinaus eventuell störende Kupferleitungen auf der Platte durchgetrennt werden. Das Befestigen der Bauteile kann dabei durch Anlöten der Bauteile an die bestehenden Kupferauflagen der Rasterplatte erfolgen. Falls allerdings die elektronischen Bauteile oder die Drahtverbindungen mehrmals an- oder ausgelötet werden oder wenn unter zu starker Hitzeentwicklung gelötet wird, besteht die Gefahr, daß sich die Kupferbeschichtung durch mechanische bzw. thermische Einflüsse von der Plattengrundschicht abhebt.

Speziell für Anwendungen in der Digitaltechnik sind Systemplatten für eine lötfreie Verbindungstechnik bekannt. Diese Platten sind entweder in bestimmten Rastermaßen mit bereits vorhandenen Steckkontakten bestückt vorhanden, oder es werden diese Kontakte nachträglich vom Benutzer an den gewünschten Stellen in die Systemplatte eingesetzt. Die Verbindung der elektronischen Bauteile untereinander geschieht je nach Ausführung in Wire Wrap-, Schneid-Klemm- (Isolationsverdrängung) oder Bond-Technik.

Der Nachteil dieser Systeme liegt ebenso wie bei den Platten in Lötausführung darin, daß durch das Raster der vorgegebenen Steckkontakte die individuelle Gestaltungsmöglichkeit von Schaltungsanordnungen stark eingeschränkt ist und sich gegebenenfalls nur durch eine aufwendige und optisch unschöne Verdrahtungstechnik, die darüber hinaus die Übersichtlichkeit der Schaltungsanordnung stark beeinträchtigt, herstellen läßt.

Steckkontakte der eingangs genannten Art sind an sich in vielfältigsten Ausführungsformen bekannt.

Das aus der US-A-3.832.603 bekannte Verbindungselement dient zum Kontaktieren von sandwichartig übereinanderliegenden Leiterplatten. Das Verbindungselement besteht aus einem Kopf mit Innenbohrung sowie einem dem vertikalen Abstand zur jeweils unteren Leiterplatte entsprechend langen Stift, der in die Bohrung des Kopfes des in der unteren Platte vorhandenen Verbindungselementes eingeführt und dort verlötet ist. Mit diesem Verbindungselement lassen sich nur vertikal genau übereinanderliegende Leitungsverbindungen zwischen verschiedenen Leiterplatten herstellen. Die Leitungsverbindungen sind darüber hinaus durch das erforderlich werdende Verlöten von Stift und Kopf übereinander angeordneter Verbindungselemente als bleibende Leitungsverbindungen konzipiert. Vor allem ist aber nachteilig, daß durch das Verbindungselement keine Leitungsverbindung zu einem auf derselben Leiterplatte benachbarten Rasterloch hergestellt werden kann, sondern daß dazu eine bauteilmäßig separate Leitungsverbindung geschaffen werden muß.

Dies ist auch bei der aus der FR-A-1.417.100 bekannten Leiterplatte der Fall. Der dort offenbarte Kontaktstift schafft keine Leitungsverbindung zu einem benachbarten Kontaktstift; die notwendig werdende Leitungsverbindung wird durch eine gedruckte Schaltungsbahn hergestellt. Diese Technik macht damit neben dem Kontaktstift einen zusätzlichen Leitungsträger erforderlich. Da der Leitungsträger regelmäßig in bestimmter flächiger Form vorliegen muß, ist ein Umstecken von elektrischen Bauteilen, wie es bei Versuchs- und Prototypen-Schaltungen regelmäßig mehrmals erforderlich wird, nicht möglich.

Die aus der GB-A-2.103.431 bekannte steckbare eletrische Verbindung für Heizelemente ist nicht für eine Kontaktierung von Leiterplatten vorgesehen oder geeignet, da die Kontaktelemente nicht fest, sondern in Aussparungen längsverschieblich beweglich geführt sind.

Nachteilig ist bei den bekannten Systemen ferner, daß zum Herstellen von lötfreien Verbindungen auf den oben erwähnten Systemplatten teilweise Spezialwerkzeuge benötigt werden -so z.B. in Form von Nietwerkzeugen, die zum Befestigen der aus der US-A-1.806.815 bekannten Kontaktelemente in Gestalt von konisch geformten Hohlnieten erforderlich werden - wodurch die einzelnen Platten um den Faktor 10 bis 20 gegenüber den Platten teurer sind, die mit der voraus beschriebenen Löttechnik behandelt werden können.

## DARSTELLUNG DER ERFINDUNG

Der Erfindung liegt die Aufgabe zugrunde, eine Möglichkeit zum Herstellen von einfach und schnell zu verwirklichenden sowie übersichtlich und sicher zu gestaltenden Leitungsverbindungen zwischen beliebigen Rastlöchern einer einfachen Lochrasterplatte zu schaffen.

Diese Erfindung ist durch die Merkmale des Hauptanspruchs gegeben. Die Erfindung zeichnet sich bei einem Steckkontakt der eingangs genannten Art dadurch aus, daß eine Öse mit kreisförmiger Aussparung an dem oberen Ende des Steckkontakts in einem derartigen Abstand zu demselben befestigt ist, daß der Abstand des Kreismittelpunktes der Aussparung zu dem Kreismittelpunkt des in einem Loch der Platte eingesteckten zylindrischen Körpers dem Rastermaß der Löcher der Lochrasterplatte entspricht, und daß der Innendurchmesser der Aussparung gleich dem Durchmesser der Lochrasterplatte ist. Diese Ausbildung eines Steckkontakts erlaubt es, einen zweiten Steckkontakt durch die an einem ersten Steckkontakt vorhandene Öse und gleichzeitig durch das dem ersten Steckkontakt benachbarte Rasterloch hindurchzustecken. Auf diese Weise sind die beiden Steckkontakte auf der Oberseite einer Lochrasterplatte elektrisch leitend miteinander verbunden. Es können so auf der Oberseite der Platte beliebig hintereinanderliegende Rasterlöcher elektrisch leitend miteinander verbunden werden. Zusätzlich ist es nach wie vor möglich, auf der Unterseite der Lochrasterplatte durch entsprechendes Verdrahten der von unten aus der Platte herausschauenden Enden der Steckkontakte zusätzliche elektrisch leitende Verbindungen herzustellen.

Durch Einstecken eines Steckkontakts in ein Loch der Lochrasterplatte und durch gleichzeitiges oder anschließendes Umbiegen der Öse in die Ebene der Lochrasterplatte ist bereits die Möglichkeit für einen elektrisch leitenden Anschluß an dieses dem Steckkontakt benachbarte Rasterloch geschaffen. Sobald in dieses benachbarte Loch ein weiterer Steckkontakt eingesteckt wird, ist die elektrisch leitende Verbindung vollzogen.

Aus fertigungstechnischen Gründen hat es sich als vorteilhaft erwiesen, die Öse einstückig mit der Wand des Körpers herzustellen und die Möglichkeit zum Abbiegen der Öse von dem Körper insbesondere dadurch zu schaffen, daß an der Stelle, an der die Öse abbiegbar am Körper des Steckkontakts befestigt ist, eine Querschnittsschwächung der Körperwandung vorhanden ist.

Da die in die Löcher einzusteckenden Füße der elektronischen Bauteile nicht alle gleich dick sind und um trotzdem zu gewährleisten, daß alle diese Füße elektrisch leitenden Kontakt mit dem Steckkontakt haben, ist in vorteilhafter Weise zumindest ein elastisch verformbares Federglied am Körper vorhanden, das in das hohle Innere des Körpers hineinragt und aus einem Wandteil des Körpers gebildet und nur in einem Teilbereich mit der übrigen Wand des Körpers verbunden ist.

Um zu verhindern, daß ein in einer Platte eingefügter Steckkontakt beispielsweise durch Einschieben eines elektrischen Verbindungsdrahtes in einen auf seiner Unterseite vorhandenen Schlitz aus der Platte nach oben herausgeschoben wird, hat es sich als vorteilhaft erwiesen, zumindest ein Sperrglied am Körper auszubilden, welches ein Herausziehen des in einem Rasterloch der Platte befindlichen Körpers durch Anlage an der Wandung des Rasterloches und/oder an der Unterseite der Platte verhindert. Dieses Sperrglied bildet damit gleichsam ein Widerlager, das sich je nach seiner geometrischen Anordnung an dem Körper des Steckkontakts in der Wandung eines Loches der Lochrasterplatte oder an der Unterseite der Platte anlegt.

Auf einfache Weise läßt sich dieses Sperrglied dadurch herstellen, daß in dem zumindest einen freien Rand eines längs aufgetrennten Körpers eines Steckkontaktes ein Einschnitt vorgesehen wird und das bezüglich der Öse unter diesem Einschnitt vorhandene angrenzende Wandteil des Körpers nach aussen schräg weggebogen wird, so daß dieses Wandteil an der Innenwandung des Rasterloches bzw. an der Unterseite der Platte sperrend anlegbar ist.

Da bei gleicher Ausbildung von Steckkontakten derjenige Steckkontakt, der in einer Öse eines anderen Steckkontaktes auf einer Platte angeordnet ist, nicht so weit unten aus der Platte herausragt wie der die Öse enthaltende erste Steckkontakt, und um trotzdem für beide Steckkontakte einen sicheren Sitz in der Platte zu gewährleisten, ist in vorteilhafter Weise in jedem der beiden freien Ränder des längsaufgeschnittenen Körpers eines jeden Steckkontaktes jeweils ein Einschnitt vorhanden, wobei die zumindest beiden Einschnitte höhenmäßig versetzt angeordnet sind. Damit ist es möglich sicherzustellen, daß sich zumindest ein Sperrglied von unten an einer Platte anlegt.

Weitere Ausgestaltungen und Vorteile der Erfindung sind den in den Ansprüchen weiterhin aufgeführten Merkmalen zu entnehmen.

## KURZE BESCHREIBUNG DER ZEICHNUNG

Die Erfindung wird im folgenden anhand des in der Zeichnung dargestellten Ausführungsbeispiels näher beschrieben und erläutert. Die der Beschreibung und der Zeichnung zu entnehmenden Merkmale können bei anderen Ausführungsformen der Erfindung einzeln für sich oder zu mehreren in beliebiger Kombination angewendet werden. Es zeigen:

Fig. 1    mehrere erfindungsgemäße Steckkontakte nach ihrer maschinellen Herstellung,

Fig. 2    eine perspektivisch auseinandergezogene Darstellung von zwei in benachbarten Löchern einer Lochrasterplatte einsteckbaren Steckkontakten,

Fig. 3    eine Schnittdarstellung von mehreren unterschiedlichen elektronischen Bauteilen auf einer Lochrasterplatte, die mit ihren jeweiligen Füßen in den erfindungsgemäßen Steckkontakten sitzen.

WEGE ZUR AUSFÜHRUNG DER ERFINDUNG

Jeder von mehreren Steckkontakten 10 ist über ein Stegstück 12 an einem plattenförmigen Steg 14 befestigt. Steckkontakt 10, Stegstück 12 und Steg 14 sind aus einem plattenförmigen Körper z. B. durch Herausstanzen hergestellt.

Der Steckkontakt 10 besitzt eine plattenförmige Öse 16, die eine kreisrunde Öffnung 18 aufweist. Diese Öse 16 ist über einen plattenförmigen Hals 20 mit einem Körper 22 einstückig verbunden.

Dieser Körper 22 ist durch Umbiegung seiner Außenwandung und durch Einschnitte in diese Außenwandung aus einem im Grundriß entsprechend geformten Plattenmaterial hergestellt.

Der Steckkontakt 10 läßt sich an der Stelle 24 von dem Stegstück 12 abtrennen, beispielsweise durch ein- oder mehrmaliges Umbiegen der Öse 16 bzw. des Stegstückes 12 an dieser Stelle 24.

Die in der Öse 16 vorhandene kreisförmige Öffnung 18 besitzt einen Innendurchmesser D, der dem Durchmesser D eines jeden der auf einer Lochrasterplatte 26 vorhandenen Löcher 28 entspricht.

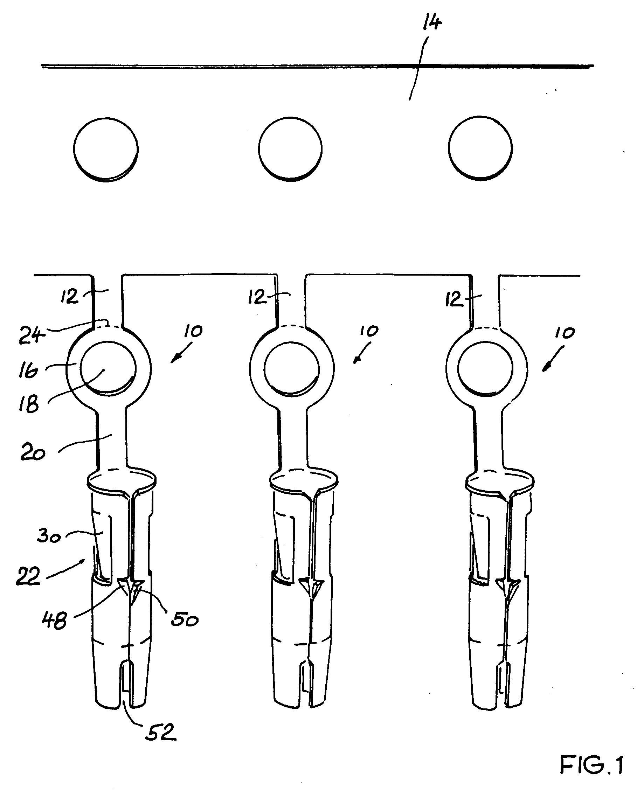

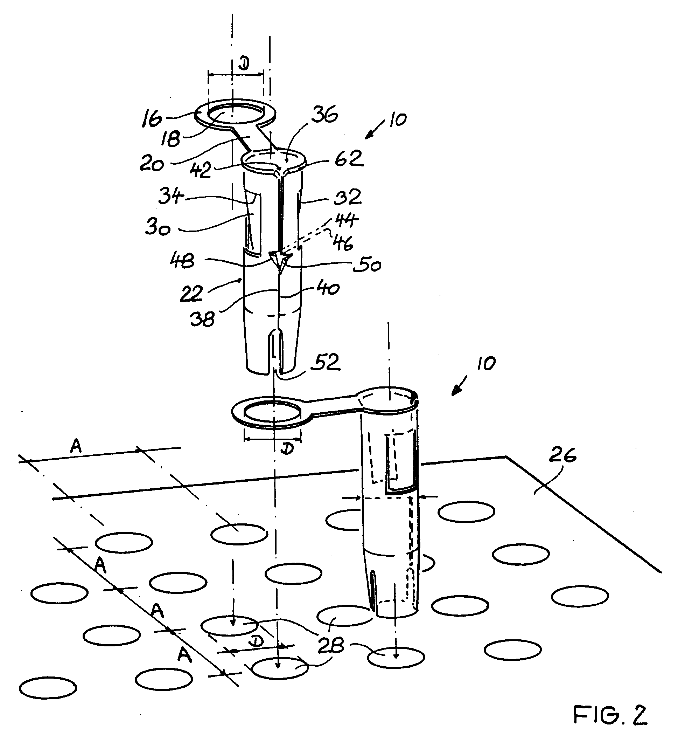

In dem in Fig. 1 und 2 dargestellten zusammengerollten Zustand des Körpers 22 besitzt derselbe einen Außendurchmesser, der ebenfalls dem Innendurchmesser D der Öffnung 18 bzw. dem der Löcher 28 entspricht. Auf diese Weise ist es möglich, den Körper 22 eines beliebigen Steckkontaktes 10 durch die Öffnung 18 eines anderen Steckkontaktes hindurchzustecken. Außerdem kann jeder Körper 22 eines beliebigen Steckkontaktes 10 in ein beliebiges Loch 28 der Lochrasterplatte 26 von oben eingeführt werden.

An dem Körper 22 sind an gegenüberliegenden Stellen jeweils ein Wandteil 30, 32 vorhanden, das längs einer oberen Linie 34 mit der übrigen Wand des Körpers 22 einstückig verbunden ist. Diese Wandteile 30, 32 sind aus der Ebene des Körpers 22 schräg in das Innere 36 des Körpers 22 hinein abgebogen. Die Linie 34 bildet dabei die Biegekante. Mit den unteren Enden ragen diese Wandteile 30, 32 damit mehr oder weniger weit in das Innere 36 des Körpers 22 hinein.

Die Wandung des in Längsrichtung einen Spalt 42 aufweisenden Körpers 22 besitzt im Bereich desselben einen linken Rand 38 und einen rechten Rand 40. Der linke Rand 38 ist an der Stelle 44 und der rechte Rand 40 an der Stelle 46 quer eingeschnitten. Das unterhalb der Stelle 44 bzw. 46 vorhandene Wandstück des Körpers 22 besitzt nach außen hin eine linke Abbiegung 48 bzw. rechte Abbiegung 50. Die Stellen 44 und 46 sind in Längsrichtung des Körpers 22 versetzt an den beiden Rändern 38, 40 vorhanden, wobei die Stelle 44 näher an dem Hals 20 als die Stelle 46 vorhanden ist. Im unteren Bereich ist der Körper 22 leicht kegelstumpfförmig ausgebildet, damit er leicht in die Öse 16 eines anderen Steckkontakts bzw. leicht in ein Loch 28 der Platte 26 eingeführt werden kann. Von der unteren Stirnseite des Körpers 22 aus ragen an zwei gegenüberliegenden Stellen der Wandung des Körpers 22 zwei Schlitze 52 in Längsrichtung - auf der Zeichnung nach oben -um ein gewisses Maß in den Körper 22 hinein.

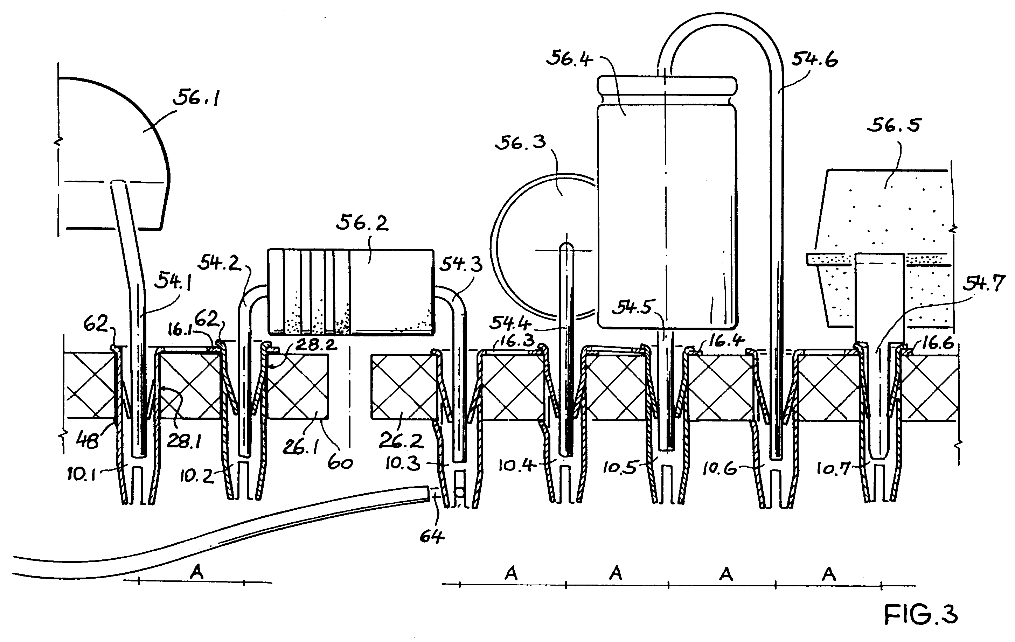

Im in die Platte 26 eingefügten Zustand ist der Hals 20 und damit auch die Öse 16 rechtwinklig vom Körper 22 abgebogen vorhanden (Fig. 2, 3). Der Hals ist so lang, daß ein in einem ersten Loch eingesteckter Steckkontakt mit der in seiner Öse 16 vorhandenen Öffnung 18 genau über einem benachbarten Loch 28 positionierbar ist. Die Löcher 28 in der Platte 26 sind in parallelen Reihen und mit einem konstanten gegenseitigen Abstand A vorhanden.

Bei der Darstellung gemäß Fig. 3 sind auf zwei Lochrasterplatten 26.1 und 26. 2 mehrere elektronische Bauteile 56 vorhanden. Jede dieser Platten ist mit den in Fig. 2 dargestellten Löchern 28 ausgestattet. In der Platte 26.1 sind in einem Loch 28.1 ein Fuß 54.1 eines Transistors 56.1 und in einem zum Loch 28.1 benachbarten Loch 28.2 ein Fuß 54.2 eines ersten Widerstandes 56.2 vorhanden. Beide Füße 54.1 und 54.2 stecken in jeweils einem Steckkontakt 10.1 bzw. 10.2. Der Steckkontakt 10.2 ist dabei außerdem von oben durch die Öse 16.1 des Steckkontakts 10.1 hindurchgeführt. An der Unterseite 60 der Platte 26.1 liegt die Oberseite der linken Abbiegung 48 des Körpers 22 an. Die rechte Abbiegung 50, die tiefer als die linke Abbiegung 48 am Körper 22 angeordnet und etwas von der Unterseite 60 entfernt positioniert ist, ist zeichnerisch nicht dargestellt. Diese rechte Abbiegung 50 liegt bei dem Steckkontakt 10.2 dagegen an der Unterseite 60 an, was in der Fig. 3 ebenfalls nicht dargestellt ist, da dies aufgrund der Tatsache, daß die Öse nach hinten in die Zeichnungsebene hinein abgeklappt vorhanden ist, und die beiden Abbiegungen etwa gegenüber von der Öse 16 am Steckkontakt vorhanden sind, nicht sichtbar ist. Der Steckkontakt 10.2 ragt mit seinem unteren Teil nicht so weit wie der Steckkontakt 10.1 aus der Platte 26. 1 heraus, da er von oben auf der Öse 16.1 des Steckkontakts 10.1 mit seinem umgebogenen Rand 62 aufliegt. Der umgebogene Rand 62 des Steckkontakts 10.1 liegt unmittelbar auf der Platte 26.1 von oben auf.

In der Platte 26.1 ist in einem Steckkontakt 10.3 der zweite Fuß 54.3 des Widerstandes 56.2 vorhanden. Ein weiterer Widerstand 56.3 ist mit einem Fuß 54.4 in einem Steckkontakt 10.4 vorhanden. Dieser Steckkontakt 10.4 sitzt in der Öse 16.3 des Steckkontaktes 10.3 von oben drin. In der Öse 16.4 des Steckkontakts 10.4 sitzt wiederum ein weiterer Steckkontakt 10.5 von oben drin, innerhalb dessen der eine Fuß 54.5 eines Kondensators 56.4 eingesteckt vorhanden ist. Der andere Fuß 54.6 dieses Kondensators 56.4 ist in einem weiteren Steckkontakt 10.6 eingesteckt vorhanden. In der Öse 16.1 dieses Steckkontaktes 10.6 sitzt ein Fuß 54.7 eines IC-Bauteils 56.5.

Der Kondensator 56.4 ist damit sowohl mit dem IC-Bauteil 56.5 als auch mit dem Widerstand 56.3 elektrisch leitend auf der Oberseite der Platte 26.2 verbunden. Der Widerstand 56.3 ist seinerseits mit dem anderen Widerstand 56.2 und außerdem mit dem Transistor 56.1 ebenfalls elektrisch leitend verbunden.

Der rechte Fuß 54.3 des einen Widerstandes 56.2 ist auf der Unterseite der Platte 26.2 über einen elektrisch leitenden Draht 64 mit einem nicht dargestellten weiteren elektronischen Bauteil elektrisch leitend verbunden. Dieser Draht 64 sitzt in dem Schlitz 52 des Bauteils 10.3 fest drin.

Es ist damit möglich, beliebige elektronische Bauteile auf der Oberseite einer Platte 26 elektrisch leitend miteinander zu verbinden und darüber hinaus auch von der Unterseite der Platte 26 her eine zusätzliche Leitungsverbindung zwischen beliebigen elektronischen Bauteilen herzustellen.

**Patentansprüche**

1. Steckkontakt zum Durchkontaktieren von Lochrasterplatten mit einem etwa zylindrischen, langgestreckten Körper, der durch jeweils ein Loch der Platte hindurchsteckbar ist,
   **dadurch gekennzeichnet,** daß
   - eine Öse (16) mit kreisförmiger Aussparung (18) an dem oberen Ende des Steckkontakts (10) in einem derartigen Abstand zu demselben befestigt ist, daß der Abstand des Kreismittelpunktes der Aussparung (18) zu dem Kreismittelpunkt des in einem Loch (28) der Platte (26) eingesteckten zylindrischen Körpers (22) dem Rastermaß (A) der Löcher (28) der Lochrasterplatte (26) entspricht,
   - der Innendurchmesser (D) der Aussparung (18) gleich dem Durchmesser (D) der Löcher (28) der Lochrasterplatte (26) ist.

2. Steckkontakt nach Anspruch 1,
   **dadurch gekennzeichnet,** daß
   die Öse (16) um ca. 90 Grad abbiegbar an dem Körper (22) befestigt ist.

3. Steckkontakt nach Anspruch 2,
   **dadurch gekennzeichnet,** daß
   die Öse (16) einstückig mit dem Körper (22) verbunden ist.

4. Steckkontakt nach Anspruch 3,
   **dadurch gekennzeichnet,** daß
   an der Stelle (24), an der die Öse (16) abbiegbar am Körper (22) befestigt ist, eine Querschnittsschwächung des Körpers (22) vorhanden ist.

5. Steckkontakt nach Anspruch 1,
   **dadurch gekennzeichnet,** daß
   zumindest ein elastisch verformbares Federglied (30, 32) am Körper (22) vorhanden ist, das in das hohle Innere (36) des Körpers (22) hineinragt, aus einem Wandteil des Körpers (22) gebildet und nur in einem Teilbereich (34) mit der übrigen Wand des Körpers (22) verbunden ist.

6. Steckkontakt nach Anspruch 1,
   **dadurch gekennzeichnet,** daß
   zumindest ein Sperrglied (48, 50) am Körper (22) vorhanden ist, welches ein Herausziehen des in einem Loch (28) der Platte (26) befindlichen Körpers (22) durch Anlage an der Wandung des Loches (28) und/oder an der Unterseite der Platte (26) verhindert.

7. Steckkontakt nach Anspruch 6,
   **dadurch gekennzeichnet,** daß
   in dem zumindest einen freien Rand (38, 40) eines längs aufgetrennten Körpers (22) ein Einschnitt (44, 46) vorhanden ist und das bezüglich der Öse (16) unter diesem Einschnitt vorhandene angrenzende Wandteil (48, 50) nach außen schräg weggebogen ist, so daß das Wandteil an der Innenwandung des Loches (28) bzw. an der Unterseite (60) der Platte (26) sperrend anlegbar ist.

**8.** Steckkontakt nach Anspruch 7,
**dadurch gekennzeichnet,** daß
in jedem der beiden freien Ränder (38, 40) des
längs aufgetrennten Körpers (22) ein Einschnitt
(44, 46) vorhanden ist, die beide höhenmäßig
versetzt angeordnet sind.

**Claims**

**1.** Plug-in contact to establish contact through
matrix boards, having an approximately cylindrical elongated body which can be plugged
through in each case one hole in the board,
characterised in that
- an eyelet (16) with a circular opening
(18) is attached to the upper end of the
plug-in contact (10) at such a distance
from the latter that the distance from the
circle centre of the opening (18) to the
circle centre of the cylindrical body (22)
plugged into a hole (28) of the plate (26)
corresponds to the grid dimension (A) of
the holes (28) in the matrix board (26),
- the inside diameter (D) of the opening
(18) is equal to the diameter (D) of the
holes (28) in the matrix board (26).

**2.** Plug-in contact according to Claim 1, characterised in that the eyelet (16) is attached to the
body (22) in such a manner that it can be bent
away by about 90 degrees.

**3.** Plug-in contact according to Claim 2, characterised in that the eyelet (16) is integrally
joined to the body (22).

**4.** Plug-in contact according to Claim 3, characterised in that the cross-section of the body
(22) is reduced at the point (24) at which the
eyelet (16) is attached to the body (22) in such
a manner that it can be bent away.

**5.** Plug-in contact according to Claim 1, characterised in that at least one elastically deformable spring member (30, 32) is present on
the body (22), which protrudes into the hollow
interior (36) of the body (22), is formed from a
wall part of the body (22) and is only connected to the remaining wall of the body (22)
in a part-area (34).

**6.** Plug-in contact according to Claim 1, characterised in that at least one locking member (48,
50) is present on the body (22), which prevents
the body (22) located in a hole (28) in the
board (26) from being pulled out by resting against the wall of the hole (28) and/or against
the underside of the board (26).

**7.** Plug-in contact according to Claim 6, characterised in that a cut-in (44, 46) is present in the
at least one free edge (38, 40) of a body (22)
which is longitudinally split open and the adjoining wall part (48, 50) existing below this
cut-in with respect to the eyelet (16) is obliquely bent away towards the outside so that
the wall part can be rested in a locking manner
against the inside wall of the hole (28) or
against the underside (60) of the board (26).

**8.** Plug-in contact according to Claim 7, characterised in that in each of the two free edges
(38, 40) of the body (22), which is longitudinally split open, a cut-in (44, 46) is present, the
two of which are arranged to be offset with
respect to height.

**Revendications**

**1.** Fiche de contact pour la métallisation de panneaux comportant des trous en réseaux, présentant un corps approximativement cylindrique et allongé qui peut être introduit chaque
fois à travers un trou du panneau,
caractérisé en ce que
- un oeillet (16) présentant un évidement
circulaire (18) est fixé à l'extrémité supérieure de la fiche de contact (10) à une
distance de celle-ci telle que la distance
entre le centre de l'évidement circulaire
(18) et le centre du corps cylindrique
(22) introduit dans un trou (28) du panneau (26) correspond à la dimension de
trame (A) des trous (28) du panneau (26)
et en ce que
- le diamètre intérieur (D) de l'évidement
(18) est égal au diamètre (D) des trous
(28) du panneau (26).

**2.** Fiche de contact suivant la revendication 1,
caractérisée en ce que l'oeillet (16) est fixé au
corps (22) de manière pliable sur environ 90°.

**3.** Fiche de contact suivant la revendication 2,
caractérisée en ce que l'oeillet (16) forme une
seule pièce avec le corps (22).

**4.** Fiche de contact suivant la revendication 3,
caractérisée en ce que, à l'emplacement (24)
auquel l'oeillet (16) est fixé de manière pliable
au corps (22), est prévue une réduction de
section du corps (22).

**5.** Fiche de contact suivant la revendication 1, caractérisée en ce que, sur le corps (22) est prévu au moins un ressort déformable élastiquement (30, 32), lequel fait saillie dans l'intérieur creux (36) du corps (22), ledit ressort étant formé par une partie de la paroi du corps (22) et n'étant relié à la paroi restante du corps (22) que dans une zone partielle (34).

6. Fiche de contact suivant la revendication 1, caractérisée en ce que, sur le corps (22) est prévu au moins un organe de blocage (48, 50) qui, par appui sur la paroi du trou (28) et/ou sur le côté inférieur du panneau (26), empêche un retrait du corps (22) se trouvant dans un trou (28) du panneau (26).

7. Fiche de contact suivant la revendication 6, caractérisée en ce que, dans au moins un bord libre (38, 40) d'un corps séparé longitudinalement (22) est prévue une entaille (44, 46) et en ce que la partie de paroi (48, 50) adjacente en dessous de cette entaille est pliée obliquement vers l'extérieur, de manière que la partie de paroi puisse être bloquée contre la paroi interne du trou (28) ou contre le côté inférieur (60) du panneau (26).

8. Fiche de contact suivant la revendication 7, caractérisé en ce que, dans les deux bords libres (38, 40) du corps séparé longitudinalement (22) sont prévues des entailles (44, 46) qui sont décalées en hauteur.

FIG.1

FIG. 2

FIG.3